Europäisches Patentamt

European Patent Office

Office européen des brevets

(11) Veröffentlichungsnummer: **0 218 088**
**B1**

(12) **EUROPÄISCHE PATENTSCHRIFT**

(45) Veröffentlichungstag der Patentschrift: **30.01.91**

(21) Anmeldenummer: **86112055.8**

(22) Anmeldetag: **01.09.86**

(51) Int. Cl.⁵: **C 30 B 11/00,** C 30 B 29/06,
C 30 B 29/60

(54) Verfahren zur gerichteten Erstarrung von Metallschmelzen.

(30) Priorität: **10.09.85 DE 3532131**

(43) Veröffentlichungstag der Anmeldung:
**15.04.87 Patentblatt 87/16**

(45) Bekanntmachung des Hinweises auf die
Patenterteilung:
**30.01.91 Patentblatt 91/05**

(84) Benannte Vertragsstaaten:
**CH DE FR GB IT LI NL**

(56) Entgegenhaltungen:
**EP-A-0 096 298**
**US-A-3 376 915**
**US-A-3 886 994**
**US-A-4 243 471**

(73) Patentinhaber: **BAYER AG**
**D-5090 Leverkusen 1 Bayerwerk (DE)**

(72) Erfinder: **Schwirtlich, Ingo, Dr.**
**Hausweberstrasse 26**
**D-4150 Krefeld (DE)**
Erfinder: **Woditsch, Peter, Dr.**
**Deswatinesstrasse 83**
**D-4150 Krefeld 1 (DE)**

Courier Press, Leamington Spa, England.

**Beschreibung**

Die vorliegende Erfindung betrifft ein Verfahren zur Herstellung von kolumnar erstarrten Metallschmelzen durch Eingießen einer Metallschmelze in eine Kokille mit nachfolgender Erstarrung in einem gerichteten Temperaturfeld, wobei an der oberen oder unteren Seite des Tiegels eine höhere Wärmeableitung herrscht als an den anderen Seiten.

Um den zukünftigen Problemen der Energieversorgung zu begegnen, besteht die Notwendigkeit, regenerierbare Energiequellen zu erschließen.

Unter ökologischen und ökonomischen Gesichtspunkten bietet sich dabei die Ausnutzung des photovoltaischen Effektes auf der Basis von Siliciumsolarzellen zur Energiegewinnung an.

Es haben sich multikristalline Siliciumscheiben für die Herstellung von Solarzellen als geeignet erwiesen. Dieses Material kann ohne Anwendung der teuren Einkristallzüchtungsverfahren hergestellt werden. Allerdings sind die Preise für multikristalline Scheiben, aus denen Solarzellen herstellbar sind, immer noch zu hoch, um eine weitere Ausweitung des Solarzellenmarktes zu bewirken.

In der Vergangenheit hat es daher nicht an Versuchen gefehlt, kostengünstige Prozesser zur Herstellung von Siliciumscheiben für Solarzellen zu entwickeln.

So ist aus der US—A—4 243 471 ein Verfahren bekannt, um kristallines Silicium durch gerichtetes Erstarren zu erhalten. Der Ausdehnung des Siliciums beim Übergang vom flüssigen in den festen Zustand um ca. 10% wird in diesem Fall dadurch begegnet, daß man Silicium nach dem Aufschmelzen in einem mittelfrequenzbeheizten Suszeptor durch langsames Absenken des Tiegels vom Boden her erstarren läßt (Bridgman-Verfahren). Durch den Einsatz einer Kokille, deren Ausdehnungskoeffizient bei 3,0—4,3 10-6 °C-1 im Temperaturbereich von 20°C—650°C liegt, soll sichergestellt sein, daß gerichtet erstarrtes Silicium in diesem Temperaturbereich keinen thermischen Spannungen ausgesetzt wird, die durch Anhaften des Siliciums an der Gefäßwand oder durch den im Vergleich zum Silicium größeren Ausdehnungskoeffizienten entstehen. Dieses Verfahren ist zwar geeignet, bei entsprechendem Aufwand ein Einsetzen der Kristallisation an der Tiegelwand zu vermeiden, es besitzt jedoch den erheblichen Nachteil, daß eine aufwendige und damit teuere Apparatur erforderlich ist und damit eine Erhöhung der Produktion durch den parallelen Betrieb mehrerer solcher Anlagen nicht zu der erwünschten Kostenreduktion führt.

Gemäß der DE—A—3 138 227 wird Silicium in einem Quarzgefäß aufgeschmolzen und auf einer Temperatur wenig oberhalb des Schmelzpunktes gehalten. Ein von vorherein am Boden des Schmelzgefäßes angebrachter einkristalliner Siliciumkeim, der durch Gaskühlung auf einer Temperatur gehalten wird, die ein Aufschmelzen verhindert, dient hier als Impfkristall. Dadurch wird bewirkt, daß im Verlauf von mehreren Stunden die Kristallisation unter Ausbildung einer konvexen Phasengrenze durch Kühlung des Siliciums vom Boden her erfolgt. Nach diesem Verfahren können überwiegend einkristalline Bereiche erhalten werden, außerdem erfolgt eine zusätzliche Reinigung der Siliciumschmelze aufgrund der unterschiedlichen Löslichkeiten der meisten Verunrenigungen in flüssigem und festem Silicium. Der Nachteil dieses sogenannten Wärmetauscherverfahrens besteht in der langsamen Erstarrung des Schmelzvolumens, da die gesamte, beim Silicium sehr hohe Schmelzwärme über die gasgekühlte Si-Einkristallplatte und die geringe Wärmekapazität des Kühlgases abgeführt werden muß. Dies führt bereits bei relativ kleinen Blöcken zu langen Kristallisationszeiten von vielen Stunden. Si-Blöcke von 20×20×10 cm³ erfordern Kristallisationszeiten von mehreren Tagen.

Die mit der langsamen Kristallisation verbundene Reinigungswirkung aufgrund der Segregationskoeffizienten für Verunreinigungen in Silicium ist allen Verfahren mit einer gerichteten und kontrolliert einstallbaren Kristallisationsgeschwindigkeit gemeinsam.

Gemäß der DE—B—2 745 247 werden Siliciumformkörper mit Kolumnarstruktur durch Eingießen einer Siliciumschmelze in eine Form und Erstarrenlassen der Schmelze erhalten, wobei man die Kontaktfläche der Gießform mit der einen der beiden größten einander gegenüber liegenden Begrenzungsflächen der Schmelze auf einer Temperatur von maximal 1200°C hält und die gegenüberliegenden Begrenzungsflächen der Schmelze einer 200° bis 1000°C darüberliegenden Temperatur, aber unterhalb des Festpunktes von Silicium, aussetzt. Anschließend erfolgt das Abkühlen der Gußkokillen, wobei die Schmelzwärme des Siliciums durch intensive Kühlung des Kokillenbodens abgeführt wird.

Aus der US—A—3376915 ist ein Verfahren zum kolumnaren Erstarren von Metallschmelzen bekannt. Hierbei herrscht an der unteren Seite des Tiegels eine höhere Wärmeableitung als an den Seiten. Den Seiten der Kokille wird dabei ein Temperaturgradient aufgeprägt. Die Zufuhr der Energie durch induktive Heizung über die Seitenwände wird allmählich reduziert, bis die Erstarrung abgefallen ist.

In beiden Fällen lassen sich Wärmeverluste durch die Kokillenwände hindurch nicht vermeiden. Die Schmelzwärme wird daher nicht nur über den Kokillenboden, sondern auch über die Seitenwände abgeführt. Die von diesen Flächen ausgehende Kristallisation führt daher zu einer ausgeprägten konkaven Fest-Flüssig-Phasengrenze, deren Fläche mit fortschreitender Erstarrung zunehmend kleiner wird. Restverunreinigungen, die an der Phasengrenze mittransportiert werden, reichern sich in der oberen Blockmitte an.

Eine mechanische Abtrennung der stark verunreinigten Bereiche von denen mit geringer Fremdatomkonzentration ist nur unter hohen Materialverlusten möglich.

Ziel der vorliegenden Erfindung ist es daher, ein einfaches und wirtschaftliches Verfahren zur Verfügung zu stellen, nach dem kolumnar erstarrte Siliciumblöcke durch Kristallisation hergestellt werden können.

Dies wird erfindungsgemäß erreicht durch ein Verfahren zur Herstellung von kolumnar erstarrten Metallschmelzen durch Eingießen einer Metallschmelze in eine Kokille mit nachfolgender Erstarrung in einem gerichteten Temperaturfeld, wobei an der oberen oder unteren Seite des Tiegels eine höhere Wärmeableitung herrscht als an den anderen Seiten, wobei bis zur vollständigen Erstarrung den Seitenwänden über die Höhe der Kokille ein Temperaturgradient so aufgeprägt wird, daß eine Wärmeabfuhr durch die Seitenwände der Kokille und die wärmere obere oder untere Seite des Tiegels vermieden wird und der wärmere untere oder obere Rand der Kokille auf einer Temperatur, die größer oder gleich der Schmelzpunkttemperatur des Metalls ist, gehlaten wird, bis die Erstarrung abgeschlossen ist.

Durch die Anwendung des erfindungsgemäßen Verfahrens kann eine annähernd konstante Flächengröße der Phasengrenze erreicht werden. Hierdurch ist die Zunahme der Verunreinigungskonzentration bei fortschreitender Erstarrung beträchtlich geringer als bei Ausbildung einer konkaven Grenzfläche.

Ein weiterer Vorteil ist die Ausbildung einer ebenen Trennfläche zwischen den Gebieten mit hoher und niedriger Verunreinigungskonzentration. Eine mechanische Abtrennung ist daher nur mit geringen Materialverlusten verbunden. Die abgetrennten verunreinigungsreichen Teile können anschließend verworfen oder wieder aufbereitet werden.

Ursächliche Voraussetzung für die Ausbildung einer ebenen Fest-Flüssig-Phasengrenze ist ein gut definierter Temperaturgradient ein Erstarrungsrichtung sowie die Vermeidung der Wärmeabfuhr durch die Kokillenwände und die wärmere untere oder obere Kokillenöffnung.

In einer bevorzugten Ausführungsform wird das erfindungsgemäße Verfahren so durchgeführt, daß der Temperaturgradient zwischen 15 K/cm und

$$\frac{\text{Schmelzpunkttemperatur [K]} - \text{Umgebungstemperatur [K]}}{\text{Höhe des Körpers [cm]}}$$

beträgt.

Das erfindungsgemäß Verfahren ist geeignet für die Reinigung verschiedener Metalle. Eine bevorzugte Ausführungsform des erfindungsgemäßen Verfahrens ist die, bei der das Metall Silicium ist.

Die Realisierung des Erfindungsgedankens ist auf unterschiedliche Art und Weise denkbar und möglich. In besonders wirtschaftlicher Weise kann das erfindungsgemäße Verfahren so durchgeführt werden, daß der Temperaturgradient mittels eines flächenförmigen Heizelementes erzeugt wird.

Dies kann so geschehen, daß ein in Hohlform angeordnetes flächenförmiges Widerstandsheizelement die Kokille eng umschließt. Dadurch kann den Kokillenwänden ein Temperaturgradient aufgeprägt werden. Eine Wärmeableitung über die Kokillenwände kann bei dieser Anordnung nur nach unten über den gekühlten Kokillenboden erfolgen. Wärmeverluste über die Kokillenöffnung können durch entsprechende Isolation sowie durch einen zusätzlichen Heizleiter über der Kokille, der in das flächenförmige Heizelement integriert sein kann, vermieden werden.

In einer besonders geeigneten Ausführungsform wird das Verfahren so durchgeführt, daß das flächenförmige Heizelement mäanderförmig geschnitten ist, und/oder unterschiedliche Materialstärken aufweist und/oder in verschiedenen Abschnitten unterschiedliche spezifische Widerstände besitzt und eine Hohlform bildet. Bevorzugt besteht das flächenförmige Heizelement aus Metallen wie Tantal, Molybdän und Niob und/oder Graphit und/oder Siliciumcarbid.

Die Erzeugung der Temperaturgradienten erfolgt über eine Veränderung der Hiezleistung durch unterschiedlich gewählte Widerstände in verschiedenen Bereichen der Widerstandsbahn. Dabei kann der Widerstand durch eine Querschnittsveränderung oder durch eine sich ändernde Materialzusammensetzung erfolgen.

Sehr einfach ist die Querschnittsänderung durchzuführen. Bei konstanter Blechdicke käßt sich dies einfach durch unterschiedlich breit gewählt Widerstandbahnen des Mäanders realisieren. Die abgegebene Leistung der einzelnen Windungsteile ist dann umgekehrt proportional zur Breite der Widerstandsbahn.

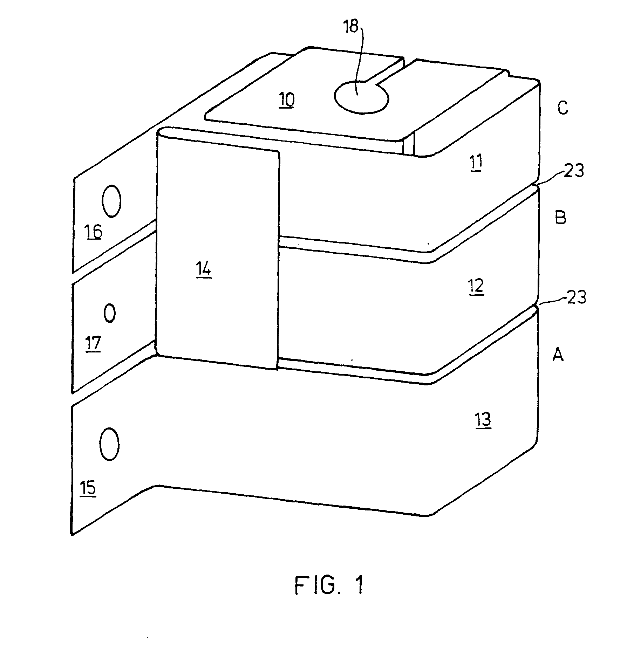

In Fig. 1 ist eine einfache Ausführungsform des Heizelements zur Durchführung des erfindungsgemäßen Verfahrens mit einer integrierten Widerstandsbahn (10) zur Beheizung der oberen Kokillenöffnung dargestellt.

Das Heizelement in Fig. 1 besteht aus drei Heizzonen (11), (12), (13) sowie der oberen Heizungsbahn (10). Die elektrische Verbindung der beiden oberen Heizerbahnen (11) und (12) erfolgt über die Lasche (14), die nach außen u-förmig abgebogen ist, um das Temperaturprofil nicht zu beeinträchtigen. Die Breite der Lasche (14) wird zweckmäßigerweise so gewählt, daß sie dem Mittelwert der Breiten der Heizungsteile (11) und (12) entspricht.

Der Stromfluß erfolgt von der einen Anschlußstelle (15) über den unteren Windungsteil (13) auf die linke Seitenwand in Fig. 1. Dort sind die Leiterbahnen (13) und (12) (in der Darstellung nicht sichtbar) miteinander verbunden. Der Strom fließ von dort über eine Leiterbahn (12) zur Verbindungsstelle (14) und gelangt in den oberen Teil (11) des Heizers. Auf dem Weg von (11) zur zweiten Anschlußstelle (16) fließt er noch über die Deckelheizung (10), die eine Öffnung (18) für einen Trichter enthalten kann. Die Lasche (17) wird nicht vom Strom durchflossen. Sie dient neben den Stromanschlußstellen der Befestigung.

3

Die Breitenverhältnisse der Leiterbahnen untereinander werden entsprechend des gewünschten Temperaturgradienten gewählt. Es hat sich herausgestellt, daß bei einer Heizung mit drei Leitungsbahnen und einer Deckelheizung die Breitenverhältnisse der unteren (A) zur mittleren (B) wie der mittleren die obere Leiterbahn (C) sowie der Bahnbreite (C) zur Breite der Deckelheizung (D) sich wie

$$\frac{A}{B}=\mu_1, \qquad \frac{B}{C}=\mu_2, \qquad \frac{C}{D}=\mu_3$$

mit $0{,}9 \le \mu_i \le 1{,}4$ (i=1, 2 oder 3) verhalten sollten, wenn der Temperaturgradient von der kühleren Unterseite zur heißeren Oberseite der Kokille gerichtet ist.

Das entsprechend Fig. 1 hergestellte Heizelement wird in eine Stützkonstruktion eingebaut, die ihm die erforderlich mechanische Festigkeit verleiht. Außerdem kann in die Stützvorrichtung die Isolation integriert sein.

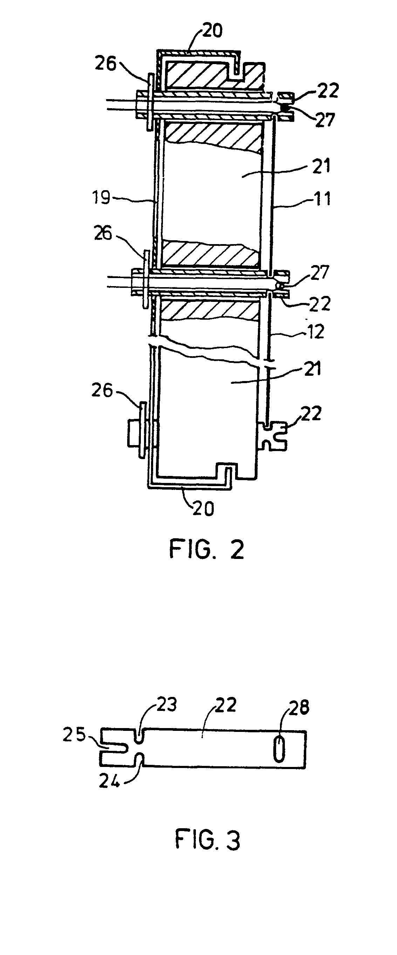

Fig. 2 zeigt einen vereinfachten Querschnitt des Aufbaus dieser Stützkonstruktion.

Sie besteht aus einem Blechmantel (19) dessen zwei gegenüberliegende Seiten (20) u-förmig abgebogen sind. In die entstehende Führung wird die Isolation (21) eingeschoben. Die Leitungsbahnen des Heizelementes (11), (12) in Fig. 2 werden durch Keramikstifte (22) gehalten, die in die Schlitze (23) zwischen den Leiterbahnen eingreifen. Dazu sind geeignete Einfassungen (23), (24) in Fig. 3 vorgesehen.

Die Stifte werden von außen durch ein Sicherungsblech (26) gehalten, das in zwei parallel angebrachte Schlitze (28) eingreift.

Die Stützkonstruktion mit dem beschriebenen Aufbau kann so ausgeführt werden, daß sie sich um die Kokille herumklappen läßt. Dazu ist bei rechteckigen Kokillen eine vierteilige Ausführung geeignet, deren einzelne Seitenflächen durch Scharniere untereinander verbunden sind. Bei runden Kokillen wird zweckmäßigerweise eine halbschalige Ausführungsform gewählt.

Die Halterung mit dem Flächenheizelement wird über die Kokille gestellt und von oben isoliert. Die Kokille befindet sich auf einer Umterlage, deren Material und Dicke die Wärmeableitung aus dem Kokillenboden in eine gekühlte Metallplatte bestimmt. Dieses Unterlage kann aus Keramiken wie Siliciumnitrid, Mullit, Aluminiumoxid oder auch Graphit in Form von Fasermaterial oder kompakt bestehen. Die Wärmeleitungseigenschaft dieser Unterlage muß mit den Heizleistungsverhältnissen der Windungsteile der Leiterbahnen abgestimmt werden.

Durch direkten Stromdurchgang wird das Heizelement auf die gewünschte Temperatur gebracht. Dabei stellt sich ein Temperaturgradient entsprechend der Breitenverhältnisse der Widerstandsbahnen, der Wärmeableitung durch den Kokillenboden und der elektrischen Gesamtleistung ein, der den Seitenwänden der Kokille aufgeprägt wird.

Wenn der gewünschte Temperaturgradient erreicht ist, kann die Schmelze über eine Trichteröffnung in der Isolation und Heizwindung an der Oberseite der Kokille eingegossen werden. Sie erstart anschließend vom Kokillenboden her unter Ausbildung unter ebenen Fest-flüssig-Phasengrenze.

Durch Thermoelemente (27), die in die Keramikrohre (22) bis an die Kokillenwand geführt werden können, ist es möglich, den Durchgang der Erstarrungsfront am Temperaturabfall zu registrieren.

Wenn die Schmelze vollständig erstarrt ist, wird die Heizleistung reduziert und der Gußkörper auf Raumtemperatur abgekühlt.

Bei dieser Verfahrensweise erhält man mit der erfindungsgemäßen Vorrichtung grobkristalline kolumnar erstarrte Körper mit Korngrößen von mehreren Zentimetern Länge und bis zu einem Zentimeter Durchmesser. Aus der vertikalen Wachstumsrichtung der Kristallkörner kann auf einen gut gerichteten Temperaturgradienten innerhalb der Kokille geschlossen werden. Die ebenmäßige Verteilung der Verunreinigungen, die mit der Erstarrungsfront transportiert wurden zeigt an, daß sich eine ebene Phasengrenzfläche ausgebildet und durch den erstarrenden Block bewegt hatte.

Durch die richtige Wahl der Erstarrungs- und Abkühlgeschwindigkeit kann die Rückdiffusion von segregierten Fremdatomen vermieden werden.

Bisher wurde der Aufbau und die Funktion der erfindungsgemäßen Vorrichtung auf der Basis eines Flächenheizelementes erläutert, das aus einem Widerstandsblech angefertigt wurde Grundsätzlich läßt sich das Heizelement auch aus Graphitfolien anfertigen, wenn die höhere Knickempfindlichkeit in der Festlegung der Geometrie berücksichtigt wird.

Bei der Verwendung von Graphitplatten für das Flächenheizelement sind Eckverbindungen für die einzelnen Leiterbahnstücke erforderlich. Der durch die Verbindungsstelle verursachte Widerstand muß durch eine entsprechende Querschnittsvergrößerung kompensiert werden.

Das folgende Beispiel soll das erfindungsgemäße Verfahren und die Vorrichtung erläutern, ohne eine Einschränkung des Erfindungsgedanken darzustellen.

Beispiel

Entsprechend Fig. 1 wurde eine mäanderförmige Widerstandsheizung ohne Deckelzusatzheizung aus 0,2 mm starkem Molybdänblech angefertigt. Der unterste Teil des Heizers (13) hatte ein Breite von 62 mm, der mittlere (12) von 48 mm und der obere (11) von 49 mm.

Dieses Flächenheizelement mit einer lichten Weite von ca. 130 mm wurde in die Stützkonstruktion bestehend aus einem Stahlmantel (19) von 1 mm Wandstärke und Graphitfaserisolation (21) von 20 mm Stärke eingebaut. Die Befestigung erfolgte über ca. 40 mm lange Röhrchen (22) aus Aluminiumoxid, die mit Sicherungsblechen (26) aus Molybdänblech gegen Herausrutschen gesichert waren. Der Abstand der Heizung zur Isolation betrug ca. 5 mm, so daß ein elektrischer Kontakt ausgeschlossen war. Als Unterlage für die Kokille wurde eine 5 mm dicke Graphitplatte gewählt, die auf einer wassergekühlten Metallplatte auflag.

In die Vorrichtung wurde eine Keramikkokille eingesetzt. Die Heizung wurde daraufhin im Vakuum durch direkten Stromdurchgang von ca. 220 A bei 13 V erhitzt. Als Folge dieser Anordnung stellte sich ein mittlerer Temperaturgradient von ca. 20 K/cm entlang der Kokillenhöhe ein.

Nach Eingießen der Siliciumschmelze (ca. 2 kg) setzte die Erstarrung mit einer Geschwindigkeit von ca. 4 cm/h ein. Im Anschluß an die vollständige Erstarrung des Gußstücks wurde die Heizleistung in ca. 12 h auf Null reduziert.

Nach Abkühlen auf Raumtemperatur konnte ein kolumnar erstarrter Siliciumblock der Kokille entnommen werden. Die ebenmäßige Verteilung der Verunreinigungen und die scharfe Trennung zwischen verunreinigungsreichen und -armen Bereichen im oberen Teil des Blockes lassen auf eine ebene Phasengrenzfläche bei der Erstarrung schließen.

## Patentansprüche

1. Verfahren zur Herstellung von kolumnar erstarrten Metallschmelzen durch Eingießen einer Metallschmelze in eine Kokille mit nachfolgender Erstarrung in einem gerichteten Temperaturfeld, wobei an der oberen oder unteren Seite des Tiegels eine höhere Wärmeableitung herrscht als an den anderen Seiten, dadurch gekennzeichnet, daß bis zur vollständigen Erstarrung den Seitenwänden über die Höhe der Kokille ein Temperaturgradient so aufgeprägt wird, daß eine Wärmeabfuhr durch die Seitenwände der Kokille und die wärmere obere oder untere Seite des Tiegels vermieden wird und der wärmere untere oder obere Rand der Kokille auf einer Temperatur, die größer oder gleich der Schmelzpunkttemperatur des Metalls ist, gehalten wird, bis die Erstarrung abgeschlossen ist.

2. Verfahren gemäß Anspruch 1, dadurch gekennzeichnet, daß der Temperaturgradient zwischen 15 K/cm und

$$\frac{\text{Schmelzpunkttemperatur [K]} - \text{Umgebungstemperatur [K]}}{\text{Höhe des Körpers [cm]}}$$

beträgt.

3. Verfahren gemäß einem der Ansprüche 1 oder 2, dadurch gekennzeichnet, daß das Metall Silicium ist.

4. Verfahren gemäß einem oder mehreren der Ansprüche 1 bis 3, dadurch gekennzeichnet, daß der Temperaturgradient mittels eines flächenförmigen Heizelementes erzeugt wird.

5. Verfahren gemäß Anspruch 4, dadurch gekennzeichnet, daß das flächenförmige Heizelement mäanderförmig geschnitten ist und/oder unterschiedliche Materialstärken aufweist und/oder in verschiedenen Abschnitten unterschiedliche spezifische Widerstände besitzt und eine Hohlform bildet.

6. Verfahren gemäß einem der Ansprüche 4 oder 5, dadurch gekennzeichnet, daß das flächenförmige Heizelement aus Metallen wie Tantal, Molybdän und Niob und/oder Graphit und/oder Siliciumcarbid besteht.

## Revendications

1. Procédé de préparation de masse métalliques fondues solidifiées sous une forme en colonne consistant à couler une masse métallique fondue dans une lingotière, avec solidification consécutive dans un champ de température orientée, et où il règne une plus grande évacuation de chaleur à la face supérieure ou à la face inférieure du creuset que sur les autres faces, caractérisé en ce que, jusqu'au moment de la solidification totale, on imprime aux parois latérales un gradient de température s'étendant selon la hauteur de la lingotière qui est de nature à éviter une évacuation de la chaleur à travers les parois latérales de la lingotière et à travers la face la plus chaude, supérieure ou inférieure, du creuset, et en ce que le bord le plus chaud, inférieur ou supérieur, de la lingotière est maintenu à une température qui est supérieure ou égale à la température du point de fusion du métal, jusqu'à ce que la solidification soit terminée.

2. Procédé selon la revendication 1, caractérisé en ce que la gradient de température est compris entre 15 k/cm et

$$\frac{\text{température du point de fusion [K]} - \text{température ambiante [K]}}{\text{hauteur du corps (cm)}}$$

3. Procédé selon une des revendications 1 et 2, caractérisé en ce que le métal est le silicium.

4. Procédé selon une ou plusieurs des revendications 1 à 3, caractérisé en ce que le gradient de température est engendré à l'aide d'un élément chauffant de forme plate.

5. Procédé selon la revendication 4, caractérisé en ce que l'élément chauffant de forme plate est découpé selon une forme sinueuse et/ou présente des épaisseurs de matière variables et/ou possède des résistances spécifiques différentes dans les différents segments et forme un moule creux.

6. Procédé selon une des revendications 4 et 5, caractérisé en ce que l'élément chauffant de forme plate est composé d'un métal tel que le tantale, le molybdène et le niobium et/ou de graphite et/ou de carbure de silicium.

**Claims**

1. Process for manufacturing columnar solidified molten metals by pouring a molten metal into a mould with subsequent solidification in a directional temperature field, there being a higher heat dissipation at the top or bottom of the crucible than at the sides, characterised in that up to complete solidification a temperature gradient is impressed upon the side walls over the height of the mould in such a manner as to prevent heat being carried away through the side walls of the mould and the hotter upper or lower side of the crucible and keep the hotter lower or upper edge of the mould at a temperature which is greater than or equal to the melting point temperature of the metal until solidification is complete.

2. Process according to claim 1, characterised in that the temperature gradient is between 15 K/cm and

$$\frac{\text{melting point temperature [K]} - \text{ambient temperature [K]}}{\text{height of the body [cm]}}$$

3. Process according to one of claims 1 or 2, characterised in that the metal is silicon.

4. Process according to one or several of claims 1 to 3, characterised in that the temperature gradient is produced by means of a laminar heating element.

5. Process according to claim 4, characterised in that the laminar heating element is cut in a meander-like manner and/or has differing material thicknesses and/or has differing specific resistances in various portions and forms a hollow shape.

6. Process according to one of claims 4 or 5, characterised in that the laminar heating element is made of metals such as tantalum, molybdenum and niobium and/or graphite and/or silicon carbide.

FIG. 1

FIG. 2

FIG. 3